(19) **Europäisches Patentamt** / **European Patent Office** / **Office européen des brevets**

(11) **EP 4 624 940 A1**

(12) **EUROPEAN PATENT APPLICATION**
published in accordance with Art. 153(4) EPC

(43) Date of publication:
01.10.2025 Bulletin 2025/40

(51) International Patent Classification (IPC):
*G01R 15/04* (2006.01)

(21) Application number: 23902236.1

(22) Date of filing: 25.09.2023

(86) International application number:
PCT/CN2023/121097

(87) International publication number:
WO 2024/125031 (20.06.2024 Gazette 2024/25)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 16.12.2022 CN 202211616418

(71) Applicants:
• China Electric Power Research Institute
Beijing 100192 (CN)
• National Center for High Voltage Measurement
Wuhan, Hubei 430074 (CN)

(72) Inventors:
• ZHOU, Feng
Wuhan, Hubei 430074 (CN)
• DIAO, Yinglong
Wuhan, Hubei 430074 (CN)
• LONG, Zhaozhi
Wuhan, Hubei 430074 (CN)
• LI, Wenting
Wuhan, Hubei 430074 (CN)
• YIN, Xiaodong
Wuhan, Hubei 430074 (CN)
• LIU, Yi
Wuhan, Hubei 430074 (CN)
• LEI, Min
Wuhan, Hubei 430074 (CN)
• FAN, Jiawei
Wuhan, Hubei 430074 (CN)
• HU, Kangmin
Wuhan, Hubei 430074 (CN)
• LIU, Shaobo
Wuhan, Hubei 430074 (CN)
• YUE, Changxi
Wuhan, Hubei 430074 (CN)
• JIANG, Chunyang
Wuhan, Hubei 430074 (CN)
• YU, Yefeng
Wuhan, Hubei 430074 (CN)
• WANG, Zhehao
Wuhan, Hubei 430074 (CN)
• HU, Haoliang
Wuhan, Hubei 430074 (CN)
• WANG, Haiyan
Wuhan, Hubei 430074 (CN)

(74) Representative: Mathys & Squire
The Shard
32 London Bridge Street
London SE1 9SG (GB)

(54) **SHIELDING RESISTIVE DIVIDER AND VOLTAGE DIVISION MEASUREMENT APPARATUS**

(57) A shielding resistive divider and a voltage division measurement apparatus. The shielding resistive divider comprises a high-voltage arm (1) and a low-voltage arm (2), the high-voltage arm (1) comprising a plurality of high-voltage modules (3) connected in series, the low-voltage arm (2) being a low-voltage module (4) which is connected in series to the bottommost high-voltage module (3) of the high-voltage arm (1). Each high-voltage module (3) comprises a measurement branch high-voltage resistor (5) and a shielding branch high-voltage resistor (6), which are electrically isolated but are connected in parallel. The low-voltage module (4) comprises a measurement branch low-voltage resistor (8) and a shielding branch low-voltage resistor (9), which are electrically isolated but are connected in parallel. In the shielding resistive divider and the voltage division measurement apparatus, the high-voltage arm (1) is modularized, namely, the high-voltage arm (1) is formed by a different number of high-voltage modules (3), such that the present application can measure voltages at different levels, and has simple mounting mode, is easy to disassemble and facilitates maintenance and repair. In addition, two electrically-isolated resistive branches are coaxially arranged in the high-voltage modules (3), thereby greatly reducing the earth stray capacitance of the high-voltage resistor (5) of the measurement branch, and shortening the response time of the voltage divider.

**(Cont. next page)**

EP 4 624 940 A1

**FIG. 1**

**Description**

CROSS-REFERENCE TO RELATED APPLICATION

The present application is based on and claims priority to Chinese Patent Application No. 202211616418.6 filed on December 16, 2022 and entitled "SHIELDING RESISTIVE DIVIDER AND VOLTAGE DIVISION MEASUREMENT APPARATUS", the disclosure of which is hereby incorporated by reference in its entirety.

TECHNICAL FIELD

The present application relates to, but is not limited to, the field of electrical measurement technology, and in particular to a shielding resistive voltage divider and a voltage division measurement apparatus.

BACKGROUND

The measurement technology of impulse voltages originated in the 1930s. In order to simulate lightning voltage signals, impulse voltage signals were generated by charging and discharging a capacitor. In addition, research on measurement technology of the impulse voltage began, and insulation withstand test of electrical devices was carried out. A sphere gap may be used to measure the impulse voltage, and the 50% breakdown voltage of the sphere gap may be used to measure the impulse voltage. To further improve measurement accuracy, researchers began to develop impulse voltage measurement apparatuses. An impulse voltage measurement apparatus includes a voltage division apparatus that converts high-voltage impulse signals into low-voltage impulse signals measurable by measurement instruments, and a measurement instrument that performs secondary voltage division on the low-voltage signals and converts them into digital signals. 80 years ago, analog oscilloscopes were mainly used to measure the impulse voltage signals, and waveform parameters were calculated manually. With technological progress of measurement instruments, currently, a data collection unit may directly convert analog signals into digital signals and achieve automatic measurement of impulse waveforms in combination with calculation and analysis software, and the waveform parameters may be directly read.

Resistive voltage dividers are mainly used to measure steep waves, lightning chopped waves and lightning full waves and have the important advantages of good response characteristics and extremely low temperature coefficients, thereby ensuring the stability of the voltage division ratio. Due to thermal capacity limitation of resistors, the resistive voltage dividers are generally not suitable for operating measurement of long-duration impulse voltages such as full waves.

For resistive voltage dividers based on the pure resistive voltage division principle, the voltage division ratio may be calculated through resistor parameters. Since stray parameters of the resistive voltage divider itself have influence on frequency characteristics of the voltage divider, the response to the impulse voltage is not ideal. The longer the response time of the resistive voltage divider is, the steeper the measured waveform is, the greater the distortion of the response of the voltage divider is, and the larger the measurement errors of the peak voltage and time parameters are. Resistors of the resistive voltage divider are generally wire-wound resistors. Since the influence of the stray parameters on high-frequency characteristics of the voltage divider cannot be ignored, when equivalence is performed on distribution parameters of the resistive voltage divider, the resistive voltage divider is divided into n identical units. For wire-wound resistors with double-wire parallel double-wire parallel winding, the inductance value increases with the increase of the resistance value, and the inductive time constant L/R tends to a constant. However, at the same time, the influence of the stray capacitance also increases. The response time of the resistive voltage divider mainly depends on the influence of the capacitance to ground.

Resistive impulse voltage dividers may be divided into centralized resistive voltage dividers and segmented resistive voltage dividers according to the structure. In a centralized resistive voltage divider, in order to improve high-frequency response characteristics of the impulse voltage dividers, a centralized wire-wound high-voltage resistor is placed on an insulating inner cylinder to reduce the stray capacitance value to ground of the resistor, thereby greatly reducing the response time of the voltage divider. Since the stray capacitance to ground is very small, there is no need to add a high-voltage grading ring for capacitance compensation, and the inductance in the stray parameters has a greater influence on square wave response. Since there are generally small grading rings at both ends of the resistor, in order to ensure insulation margin, when the voltage level increases, the diameter of the voltage divider increases accordingly, and the rated voltage is generally less than 1000kV In a segmented resistive voltage divider, the high-voltage resistor runs through the entire height of the voltage divider and has a small diameter, and the main limitation of the voltage level is insulation of the resistance wire itself. The disadvantage is that the high-voltage resistor is long, and the stray capacitance to ground has a greater influence on the square wave response.

In summary, for existing resistive impulse voltage dividers, on one hand, the measurable voltage level is about 1000kV On the other hand, with further increase of the rated voltage, in order to reduce heating of the resistor, the value of the wire-wound resistor increases. Therefore, it is necessary to increase the diameter and number of turns of the resistance wire. The length of the resistor increases, and the step wave response time increases. Due to limitation of external insulation, the height of the voltage divider needs to be further increased, and compensation difficulty of distribution capacitance to the ground increases. In addition, the height of the voltage divider is so high that installation is inconvenient.

SUMMARY

In order to solve the problems in the related art (i.e., the voltage level measurable by the resistive voltage divider is limited, and when the voltage level to be measured is increased, it is necessary to increase the diameter and number of turns of the resistance wire and lengthen the resistor, thereby increasing the height of the voltage divider complicating the installation), the present application provides a shielding resistive voltage divider and a voltage division measurement apparatus.

According to an aspect of the present application, the present application provides a shielding resistive voltage divider including a high-voltage arm and a low-voltage arm.

The high-voltage arm includes multiple high-voltage modules connected in series, and the low-voltage arm is a low-voltage module connected in series with a high-voltage module at a tail end of the high-voltage arm.

For each high-voltage module of the multiple high-voltage modules, the high-voltage module includes a measurement branch high-voltage resistor and a shielding branch high-voltage resistor connected in parallel, and a first insulating housing. Here, the measurement branch high-voltage resistor and the shielding branch high-voltage resistor are coaxially disposed within the first insulating housing and are electrically isolated from each other. The shielding branch high-voltage resistor is located outside the measurement branch high-voltage resistor.

The high-voltage module further includes a first flange and a second flange.

The first flange is located at a top of the first insulating housing, and is configured to crimp the measurement branch high-voltage resistor and the shielding branch high-voltage resistor from the top. A hollow column is disposed at a bottom of the first flange, and multiple annular grooves are formed on an inner peripheral wall of the hollow column along an axial direction.

The second flange is located at a bottom of the first insulating housing, and is configured to achieve connection between adjacent high-voltage modules and connection between the high-voltage module at the tail end of the high-voltage arm and the low-voltage module. Here, in a high-voltage module that is not at the tail end of the high-voltage arm, a hollow column is disposed at a top of the second flange, and multiple annular grooves are formed on an inner peripheral wall of the hollow column along an axial direction. In the high-voltage module at the tail end of the high-voltage arm, a respective hollow column is disposed on each of the top and a bottom of the second flange, and multiple annular grooves are formed on an inner peripheral wall of each hollow column along an axial direction.

The low-voltage module includes a measurement branch low-voltage resistor and a shielding branch low-voltage resistor connected in parallel, and a second insulating housing. Here, the measurement branch low-voltage resistor and the shielding branch low-voltage resistor are coaxially disposed within the second insulating housing, and a high-voltage end of the measurement branch low-voltage resistor and a high-voltage end of the shielding branch low-voltage resistor are electrically isolated from each other. The shielding branch low-voltage resistor is located outside the measurement branch low-voltage resistor.

The low-voltage module further includes a high-low voltage insulating plate, a low-voltage resistor base plate and a lower flange. Here, the low-voltage resistor base plate is configured to fix low-voltage ends of the measurement branch low-voltage resistor and the shielding branch low-voltage resistor. The high-low voltage insulating plate is crimped to a top of the second insulating housing. The lower flange is crimped to the low-voltage resistor base plate and a bottom of the second insulating housing, and is configured to fix the measurement branch low-voltage resistor and the shielding branch low-voltage resistor.

Measurement branch high-voltage resistors in the multiple high-voltage modules are electrically connected through at least one connection metal component, and shielding branch high-voltage resistors in the multiple high-voltage modules are electrically connected through at least one connection metal component. A measurement branch high-voltage resistor in the high-voltage module at the tail end of the high-voltage arm and the measurement branch low-voltage resistor in the low-voltage module are electrically connected through at least one connection metal component. A shielding branch high-voltage resistor in the high-voltage module at the tail end of the high-voltage arm and the shielding branch low-voltage resistor in the low-voltage module are electrically connected through at least one connection metal component.

In some embodiments, the measurement branch high-voltage resistors in the multiple high-voltage modules are electrically connected through the at least one connection metal component, the shielding branch high-voltage resistors in the multiple high-voltage modules are electrically connected through the at least one connection metal component, the measurement branch high-voltage resistor in the high-voltage module at the tail end of the high-voltage arm and the measurement branch low-voltage resistor in the low-voltage module are electrically connected through the at least one connection metal component, and the shielding branch high-voltage resistor in the high-voltage module at the tail end of the high-voltage arm and the shielding branch low-voltage resistor in the low-voltage module are electrically connected through the at least one connection metal component, which may include the following cases.

In a high-voltage module at a head end of the high-voltage arm, a first connection component is disposed at head ends of the measurement branch high-voltage resistor and the shielding branch high-voltage resistor, a second connection component is disposed at an tail end of the measurement branch high-voltage resistor, and a third connection component is disposed at an tail end of the shielding branch high-voltage resistor.

In a high-voltage module that is not at the head end of the high-voltage arm, the second connection component is disposed at the head end and the tail end of the measurement branch high-voltage resistor, and the third connection component is disposed at the head end and the tail end of the shielding branch high-voltage resistor.

In the high-voltage module that is not at the tail end of the high-voltage arm, a fourth connection component is disposed on the second flange. Here, the fourth connection component is coaxially disposed with the second connection component.

In the high-voltage module at the tail end of the high-voltage arm, a fifth connection component is disposed on the second flange. In the high-voltage module that is not at the head end of the high-voltage arm, the fifth connection component is disposed on the first flange. Here, the fifth connection component is coaxially disposed with the second connection component.

A sixth connection component and a seventh connection component are fixed on the high-low voltage insulating plate of the low-voltage module. Here, the sixth connection component and the seventh connection component are coaxially disposed with the fifth connection component.

In the low-voltage module, an eighth connection component is disposed at the high-voltage end of the measurement branch low-voltage resistor, and a ninth connection component is disposed at the high-voltage end of the shielding branch low-voltage resistor.

In some embodiments, in each high-voltage module of the multiple high-voltage modules, the measurement branch high-voltage resistor and the shielding branch high-voltage resistor may be double-wire parallel wound around an insulating support rod. The measurement branch high-voltage resistor and the shielding branch high-voltage resistor may have a consistent potential at a same physical height, a same number of turns, and an equal turn spacing. Here, when the measurement branch high-voltage resistor and the shielding branch high-voltage resistor are wound with resistance wires of a same diameter, a ratio of resistance values is equal to a ratio of resistor diameters. When the measurement branch high-voltage resistor and the shielding branch high-voltage resistor are wound with resistance wires of different diameters, a diameter of a resistance wire of the measurement branch high-voltage resistor is smaller than a diameter of a resistance wire of the shielding branch high-voltage resistor.

In some embodiments, when the multiple high-voltage modules are connected in series, a turn spacing of the measurement branch high-voltage resistor and the shielding branch high-voltage resistor in the high-voltage module may change according to a distance to the low-voltage module, and the closer to the low-voltage module is, the larger the turn spacing is.

In some embodiments, a respective first grading ring may be disposed between each end of the shielding branch high-voltage resistor and an inner wall of the first insulating housing.

A second grading ring may be disposed between any two adjacent high-voltage modules.

A third grading ring may be disposed at a top end of a first insulating housing of the high-voltage module at the head end of the high-voltage arm. The third grading ring is designed to be scalable, and a final height for disposing the third grading ring is determined according to a step wave response test result.

In some embodiments, the shielding resistive voltage divider may further include a damping resistor and a high-voltage guide rod.

The high-voltage guide rod is disposed on a first flange of the high-voltage module at the head end of the high-voltage arm. The damping resistor is connected with the measurement branch high-voltage resistor and the shielding branch high-voltage resistor through a high-voltage lead wire and the high-voltage guide rod in sequence.

In some embodiments, the low-voltage arm of the shielding resistive voltage divider may further include a first matching resistor and a radio frequency cable socket connected in parallel with the measurement branch low-voltage resistor.

The radio frequency cable socket is disposed on the lower flange of the low-voltage module, and the radio frequency cable socket is coaxial with the first matching resistor.

An end of the first matching resistor is connected with the high-voltage end of the measurement branch low-voltage resistor, and another end of the first matching resistor is connected with a core wire of a cable installed in the radio frequency cable socket.

In some embodiments, the high-voltage module and the low-voltage module may be internally air insulated.

According to another aspect of the present application, the present application provides a shielding resistive voltage division measurement apparatus. The measurement apparatus includes a shielding resistive voltage divider, a cable, a second matching resistor, a measurement instrument and a shielding cabinet.

The cable is coaxially connected with a first matching resistor of the shielding resistive voltage divider and is connected in parallel with the second matching resistor. Here, the number of high-voltage modules to be installed in the shielding resistive voltage divider is determined according to a voltage level to be measured.

The measurement instrument is connected with the second matching resistor and the cable, and is configured to measure a voltage. Here, the measurement instrument and the second matching resistor are sealed within the shielding cabinet.

Embodiments of the present application provide a shielding resistive voltage divider and a voltage division measurement apparatus. Here, the shielding resistive voltage divider includes a high-voltage arm and a low-voltage arm. The high-voltage arm includes multiple high-voltage modules connected in series, and the low-voltage arm is a low-voltage module connected in series with the high-voltage module at the tail end of the high-voltage arm. The high-voltage module includes a measurement branch high-voltage resistor and a shielding branch high-voltage resistor that are electrically isolated but connected in parallel. The low-voltage module includes a measurement branch low-voltage resistor and a shielding branch low-voltage resistor that are electrically isolated but connected in parallel. Measurement branch high-voltage resistors in the multiple high-voltage modules are electrically connected through at least one connection metal component. Shielding branch high-voltage resistors in the multiple high-voltage modules are electrically connected through at least one connection metal component. A measurement branch high-voltage resistor in the high-voltage module at the tail end of the high-voltage arm and the measurement branch low-voltage resistor in the low-voltage module are electrically connected through at least one connection metal component. A shielding branch high-voltage resistor in the high-voltage module at the tail end of the high-voltage arm and the shielding branch low-voltage resistor in the low-voltage module are electrically connected through at least one connection metal component. The high-voltage arm in the shielding resistive voltage divider and the voltage division measurement apparatus is modularized. The high-voltage arm is composed of different numbers of high-voltage modules, which may measure different voltage levels and is easy for installation, disassembly, and maintenance. Two electrically isolated resistor branches are coaxially disposed in the high-voltage module, which have the same height and thus have the same potentials theoretically. In this way, the stray capacitance to ground of the measurement branch high-voltage resistor is greatly reduced, and the response time of the voltage divider is reduced.

BRIEF DESCRIPTION OF THE DRAWINGS

In order to illustrate the technical solutions in the specific implementations of the present application more clearly, drawings to be used in the description of the specific implementations will be briefly introduced below. It is apparent that the drawings described below are some implementations of the present application. The drawings of the Specification that constitute a part of the present application are used to provide further understanding of the present application. Exemplary embodiments of the present application and illustration thereof are used to explain the present application and do not constitute an undue limitation of the present application. For those of ordinary skill in the art, other drawings may also be obtained according to these drawings without making creative efforts.

FIG. 1 is a schematic diagram of a structure of a shielding resistive voltage divider provided by an embodiment of the present application.

FIG. 2 is a diagram of a circuit principle of a shielding resistive voltage divider provided by an embodiment of the present application.

FIG. 3 is a schematic diagram of distribution of a number of turns of a high-voltage resistor of a shielding resistive voltage divider provided by an embodiment of the present application.

FIG. 4 is a schematic diagram of a structure of a shielding voltage division measurement apparatus provided by an embodiment of the present application.

FIG. 5 is a schematic diagram of a test circuit for measuring a voltage division ratio of a shielding resistive voltage division apparatus provided by an embodiment of the present application.

DETAILED DESCRIPTION

Exemplary implementations of the present application are introduced with reference to the drawings. However, the present application may be implemented in many different forms and is not limited to the embodiments described herein. These embodiments are provided to fully and completely describe the present application and to sufficiently convey the scope of the present application to those skilled in the relevant technical field. Terms in the exemplary implementations shown in the drawings are not intended to limit the present application. In the drawings, the same unit/element is denoted by the same reference numeral.

Unless otherwise specified, terms used herein (including technical terms) have general meanings to those skilled in the relevant technical field. Further, it is to be understood that terms limited by commonly used dictionaries should be understood as having meanings consistent with their context in the relevant field and should not be understood in an idealized or overly formal sense.

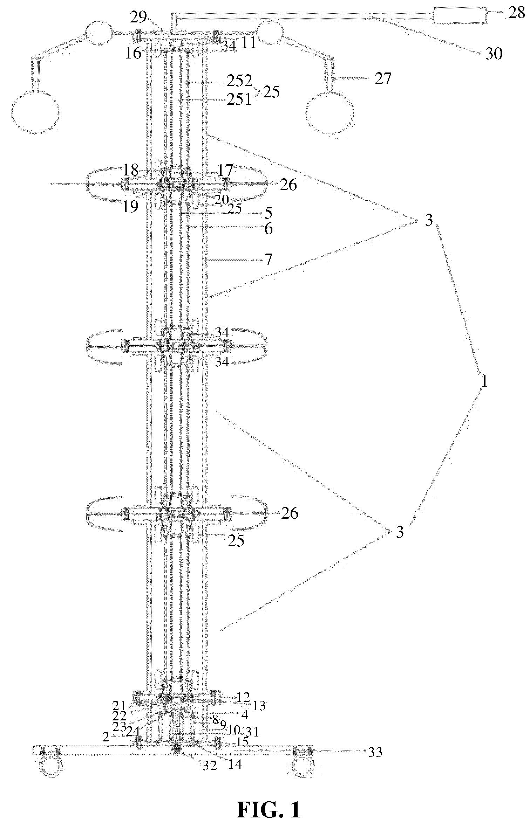

FIG. 1 is a schematic diagram of a structure of a shielding resistive voltage divider provided by an embodiment of the present application. As shown in FIG. 1, the shielding resistive voltage divider of the embodiment of the present application includes a high-voltage arm 1 and a low-voltage arm 2.

The high-voltage arm 1 includes multiple high-voltage modules 3 connected in series, and the low-voltage arm 2 is a low-voltage module 4 connected in series with a high-voltage module 3 at the tail end of the high-voltage arm.

For each high-voltage module 3 of the multiple high-voltage modules 3, the high-voltage module 3 includes a measurement branch high-voltage resistor 5 (i.e., a high-voltage resistor in the measurement branch) and a shielding branch high-voltage resistor 6 (i.e., a high-voltage resistor in the shielding branch) connected in parallel, and a first insulating housing 7. Here, the measurement branch high-voltage resistor 5 and the shielding branch high-voltage resistor 6 are coaxially disposed within the first insulating housing 7 and are electrically isolated from each other. The shielding branch high-voltage resistor 6 is located outside the measurement branch high-voltage resistor 5.

The low-voltage module 4 includes a measurement branch low-voltage resistor 8 (i.e., a low-voltage resistor in the measurement branch) and a shielding branch low-voltage resistor 9 (i.e., a low-voltage resistor in the shielding branch) connected in parallel, and a second insulating housing 10. Here, the measurement branch low-voltage resistor 8 and the shielding branch low-voltage resistor 9 are coaxially disposed within the second insulating housing 10, and a high-voltage end of the measurement branch low-voltage resistor 8 and a high-voltage end of the shielding branch low-voltage resistor 9 are electrically isolated from each other. The shielding branch low-voltage resistor 9 is located outside the measurement branch low-voltage resistor 8.

The measurement branch high-voltage resistors 5 in the multiple high-voltage modules 3 are electrically connected through at least one connection metal component, and the shielding branch high-voltage resistors 6 in the multiple high-voltage modules 3 are electrically connected through at least one connection metal component. The measurement branch high-voltage resistor 5 in the high-voltage module 3 at the tail end of the high-voltage arm 1 and the measurement branch low-voltage resistor 8 in the low-voltage module are electrically connected through at least one connection metal component. The shielding branch high-voltage resistor 6 in the high-voltage module 3 at the tail end of the high-voltage arm 1 and the shielding branch low-voltage resistor 9 in the low-voltage module are electrically connected through at least one connection metal component.

Referring to FIG. 1, FIG. 1 is the schematic diagram of a structure of the shielding resistive voltage divider provided by the embodiment of the present application. In the embodiment, there are four high-voltage modules. When each high-voltage module may measure a voltage level of 600kV, it is possible to measure a voltage level of 2400kV by connecting four high-voltage modules in series. The first insulating housing 7 of the high-voltage module 3 and the second insulating housing 10 of the low-voltage module 4 are both of cylindrical structures, and the material may be epoxy glass fiber cylinder. Thus, it can be seen that the high-voltage arm is designed to be modular, and the installation manner is easy. Depending on different connection manners, the high-voltage arm is composed of multiple high-voltage modules with the same voltage, and measurements of lightning full waves and lightning chopped waves of different voltage levels, such as 600kV, 1200kV, 1800kV, 2400kV, may be achieved through different high-voltage installation manners.

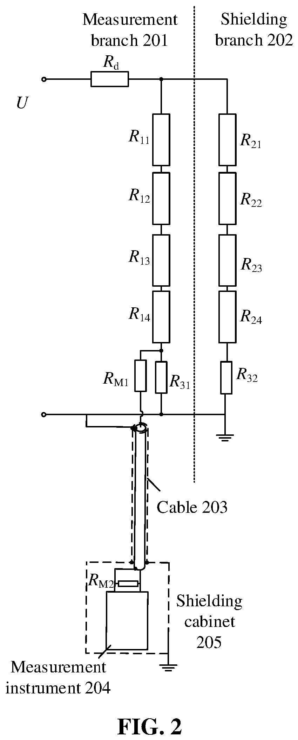

FIG. 2 is a diagram of a circuit principle of a shielding resistive voltage divider provided by an embodiment of the present application. As shown in FIG. 2, $R_d$ is a damping resistor, $R_{11}$ to $R_{14}$ are measurement branch high-voltage resistors, $R_{21}$ to $R_{24}$ are shielding branch high-voltage resistors, $R_{M1}$ is a head end matching resistor, $R_{31}$ is a measurement branch low-voltage resistor, $R_{22}$ is a measurement branch low-voltage resistor, and $R_{M2}$ is a tail end matching resistor. Here, the circuit at least includes a measurement branch 201, a shielding branch 202 and a cable 203. The cable 203 is coaxially connected with the head end matching resistor $R_{M1}$ and is connected in parallel with the tail end matching resistor $R_{M2}$. A measurement instrument 204 is connected with the tail end matching resistor $R_{M2}$ and the cable 203, and is configured to measure voltages. Here, the measurement instrument 204 and the tail end matching resistor $R_{M2}$ are sealed within a shielding cabinet 205.

In some embodiments, continuously referring to FIG. 1, the high-voltage module 3 further includes a first flange 11 and a second flange 12.

The first flange 11 is located at the top of the first insulating housing 7, and is configured to crimp the measurement branch high-voltage resistor 5 and the shielding branch high-voltage resistor 6 from the top. A hollow column is disposed at the bottom of the first flange 11, and multiple annular grooves are formed on the inner peripheral wall of the hollow column along the axial direction.

The second flange 12 is located at the bottom of the first insulating housing 7, and is configured to achieve connection between the high-voltage modules and connection between the high-voltage module at the tail end of the high-voltage arm and the low-voltage module. Here, in a high-voltage module that is not at the tail end of the high-voltage arm, a hollow column is disposed at the top of the second flange 12, and multiple annular grooves are formed on the inner peripheral wall of the hollow column along the axial direction. In the high-voltage module at the tail end of the high-voltage arm, a respective hollow column is disposed on each of the top and the bottom of the second flange 12, and multiple annular grooves are formed on the inner peripheral wall of each hollow column along the axial direction.

The low-voltage module 4 further includes a high-low voltage insulating plate 13, a low-voltage resistor base plate 14 and a lower flange 15. Here, the low-voltage resistor base plate 14 is configured to fix the low-voltage ends of the measurement branch low-voltage resistor 8 and the shielding branch low-voltage resistor 9. The high-low voltage insulating plate 13 is crimped to the top of the second insulating housing 10. The lower flange 15 is crimped to the low-voltage resistor base plate 14 and the bottom of the second insulating housing 10, and is configured to fix the measurement branch low-voltage resistor and the shielding branch low-voltage resistor. Referring to FIG. 1, it can be known that the low-voltage module is an independent unit, which is very convenient for disassembly and maintenance, and can be combined with different high-voltage modules to form a new shielding resistive voltage divider.

In some embodiments, the measurement branch high-voltage resistors in the multiple high-voltage modules are electrically connected through the at least one connection metal component, the shielding branch high-voltage resistors in the multiple high-voltage modules are electrically connected through the at least one connection metal component, the measurement branch high-voltage resistor in the high-voltage module at the tail end of the high-voltage arm and the measurement branch low-voltage resistor in the low-voltage module are electrically connected through the at least one connection metal component, and the shielding branch high-voltage resistor in the high-voltage module at the tail end of the high-voltage arm and the shielding branch low-voltage resistor in the low-voltage module are electrically connected through the at least one connection metal component, which may include the following cases.

In a high-voltage module at the head end of the high-voltage arm, a first connection component 16 is disposed at the head ends of the measurement branch high-voltage resistor and the shielding branch high-voltage resistor. A second connection component 17 is disposed at the tail end of the measurement branch high-voltage resistor, and a third connection component 18 is disposed at the tail end of the shielding branch high-voltage resistor.

In a high-voltage module that is not at the head end of the high-voltage arm, the second connection component 17 is disposed at the head end and the tail end of the measurement branch high-voltage resistor, and the third connection component 18 is disposed at the head end and the tail end of the shielding branch high-voltage resistor.

In the high-voltage module that is not at the tail end of the high-voltage arm, a fourth connection component 19 is disposed on the second flange. Here, the fourth connection component 19 is coaxially disposed with the second connection component 17.

In the high-voltage module at the tail end of the high-voltage arm, a fifth connection component 20 is disposed on the second flange. In the high-voltage module that is not at the head end of the high-voltage arm, the fifth connection component 20 is disposed on the first flange. Here, the fifth connection component 20 is coaxially disposed with the second connection component 17.

A sixth connection component 21 and a seventh connection component 22 are fixed on the high-low voltage insulating plate 13 of the low-voltage module. Here, the sixth connection component 21 and the seventh connection component 22 are coaxially disposed with the fifth connection component 20.

In the low-voltage module, an eighth connection component 23 is disposed at the high-voltage end of the measurement branch low-voltage resistor, and a ninth connection component 24 is disposed at the high-voltage end of the shielding branch low-voltage resistor.

In some embodiments, in each high-voltage module 3 of the multiple high-voltage modules 3, the measurement branch high-voltage resistor 5 and the shielding branch high-voltage resistor 6 are double-wire parallel wound around an insulating support rod. The measurement branch high-voltage resistor 5 and the shielding branch high-voltage resistor 6 have a consistent potential at the same physical height, the same number of turns, and an equal turn spacing. Here, when the measurement branch high-voltage resistor 5 and the shielding branch high-voltage resistor 6 are wound with resistance wires of the same diameter, the ratio of resistance values is equal to the ratio of resistor diameters. When the measurement branch high-voltage resistor 5 and the shielding branch high-voltage resistor 6 are wound with resistance wires of different diameters, the diameter of the resistance wire of the measurement branch high-voltage resistor is smaller than the diameter of the resistance wire of the shielding branch high-voltage resistor.

Referring to FIG. 1, in the embodiment, to achieve connection between the high-voltage modules, a respective first flange 11 and a respective second flange 12 are disposed on each high-voltage module, which are crimped to the first insulating housing 7 and are configured to fix the measurement branch high-voltage resistor and the shielding branch high-voltage resistor in the high-voltage module. In addition, the first flanges 11 and the second flanges 12 of adjacent two high-voltage modules are fixed together through bolts to form the high-voltage arm 1. Since the measurement branch high-voltage resistor 5 needs to be electrically isolated from the shielding branch high-voltage resistor 6 in each of the high-voltage modules 3 connected in series while requiring the electrical connection between the measurement branch high-voltage resistors 5 across the high-voltage modules 3 and the electrical connection between the shielding branch high-voltage resistors 6 across the high-voltage modules 3, the measurement branch high-voltage resistor 5 and the shielding branch high-voltage resistor 6 in each high-voltage module 3 are electrically isolated from each other via an insulating support rod 25. The insulating support rod 25 includes a solid cylindrical insulating support rod 251 and a ring-shaped cylindrical insulating support rod 252 that are coaxially disposed. Here, the resistance wire is wound around the solid cylindrical insulating support rod 251 in double-wire parallel double-wire parallel winding to obtain the measurement branch high-voltage resistor 5. The ring-shaped cylindrical insulating support rod 252 is disposed outside the measurement branch high-voltage resistor 5, and the resistance wire is wound around the ring-shaped cylindrical insulating support rod 252 in double-wire parallel double-wire parallel winding to obtain the shielding branch high-voltage resistor 6. The measurement branch high-voltage resistor 5 and the shielding branch high-voltage resistor 6 are wound with the same resistance wire, and the resistance wire in each high-voltage module 3 has a consistent turn spacing. Such structure may ensure that the inner and outer resistors have equal potentials at the same height, which significantly reduces the stray capacitance to ground of the inner layer high-voltage resistor and improves the high-frequency response characteristics of the voltage conversion branch.

In some embodiments, electrical connection between the measurement branch high-voltage resistors 5 in the high-voltage modules 3, electrical connection between the shielding branch high-voltage resistors 6 in the high-voltage modules 3, electrical connection between the measurement branch high-voltage resistors of the high-voltage modules and the measurement branch low-voltage resistor of the low-voltage module, and electrical connection between the shielding branch high-voltage resistors of the high-voltage modules and the shielding branch low-voltage resistor of the low-voltage module are achieved by disposing connection metal components.

Specifically, the first connection component 16 to the ninth connection component 24 may be copper connection components. The first connection component 16 may be a cylindrical structure with an open bottom. Multiple first connection holes are circumferentially provided near the center of the top, which are configured to connect with the measurement branch high-voltage resistor 5 through bolts respectively. Multiple second connection holes are circumferentially provided along the side wall below, which are configured to connect with the shielding branch high-voltage resistor 6 through bolts respectively. Through the first connection component 16, the measurement branch high-voltage resistor 5 and the shielding branch high-voltage resistor 6 in the high-voltage arm 1 are connected in parallel to form a voltage division circuit. Theoretically, the measurement branch and the shielding branch have the same potential at the same physical height, which is conducive to reducing the stray capacitance to ground of the high-voltage resistor on the measurement branch, thereby reducing the response time of the voltage division apparatus.

The second connection component 17 is disposed at the tail end of the high-voltage module that is at the head end of the high-voltage arm, and at the head end and tail end of the high-voltage module that is not at the head end of the high-voltage arm. It may be a cylindrical structure with an open end. Multiple bolt holes are provided along the horizontal direction on the side wall of the open end. The second connection component 17 is coaxial with the measurement branch high-voltage resistor 5. The second connection component 17 located at the tail end of the high-voltage module is open upwards, and the second connection component 17 located at the head end of the high-voltage module is open downwards. By installing bolts at the open end, the second connection component 17 is fixed on an insulating support rod 241.

The fourth connection component 19 is disposed on the second flange 12 of the high-voltage module that is not at the tail end of the high-voltage arm, and may be a cylindrical structure flush with the top of the second flange 12. Multiple bolt holes are circumferentially provided at the bottom of the cylindrical structure, and a hollow column is disposed at the top of the cylindrical structure. Multiple annular grooves are formed along the axial direction on the inner peripheral wall of the hollow column. A cylindrical structure is disposed at the bottom of the cylindrical structure, which protrudes from the bottom of the second flange 12 and has a diameter smaller than that of the second connection component 17. The fifth connection component 20 is disposed on the first flange 11 of the high-voltage module that is not at the head end of the high-voltage arm and on the second flange 12 of the high-voltage module at the tail end of the high-voltage arm. The fifth connection component 20 may be a cylindrical structure flush with the bottom of the first flange 11 of the high-voltage module that is not at the head end of the high-voltage arm and flush with the top of the second flange 12 of the high-voltage module at the tail end of the high-voltage arm. Multiple bolt holes are circumferentially provided at the top of the cylindrical structure, and a respective hollow column is disposed at the top and bottom of the cylindrical structure. Multiple annular grooves are formed along the axial direction on the inner peripheral wall of the hollow column. By mounting spring contact fingers 34 at the positions of the annular grooves of the fourth connection component 19 and the fifth connection component 20, the electrical connection between the measurement branch high-voltage resistors in the high-voltage modules may be achieved.

The third connection component 18 is disposed at the tail end of the high-voltage module that is at the head end of the high-voltage arm, and at the head end and tail end of the high-voltage module that is not at the head end of the high-voltage arm. It is also coaxial with the measurement branch high-voltage resistor 5 and may be a hollow cylindrical structure. By installing bolts on the tubular wall, the third connection component 18 is fixed on the insulating support rod 242. A hollow column is disposed at the top of the second flange 12 of the high-voltage module that is not at the tail end of the high-voltage arm, and multiple annular grooves are formed along the axial direction on the inner peripheral wall of the hollow column. A hollow column is disposed at the bottom of the first flange 11 of the high-voltage module that is not at the head end of the high-voltage arm, and multiple annular grooves are formed along the axial direction on the inner peripheral wall of the hollow column. Therefore, electrical connection between adjacent third connection components 18 may be achieved by mounting the spring contact fingers 34 at the positions of the above annular grooves, thereby achieving electrical connection between the shielding branch high-voltage resistors 6 in the high-voltage modules. As can be seen from FIG. 1, the third connection component 18 is isolated from the second connection component 17, the fourth connection component 19 and the fifth connection component 20 through insulating materials, and the hollow columns on the first flange 11 and the second flange 12 are isolated from the fourth connection component 19 and the fifth connection component 20 through insulating materials. Thus, when electrical connection between the measurement branch high-voltage resistors in the high-voltage modules and electrical connection between the shielding branch high-voltage resistors in the high-voltage modules are achieved, electrical isolation between the measurement branch high-voltage resistors and the shielding branch high-voltage resistors in all the high-voltage modules is also achieved.

In the low-voltage module 4, the sixth connection component 21 to the ninth connection component 24 are provided. Here, the sixth connection component 21 is a cylindrical structure with a ring-shaped cylinder at the bottom, and the seventh connection component 22 is a cylindrical structure with a fully open top and a partially open bottom. The sixth connection component 21 and the seventh connection component 22 are coaxially connected with a high-low voltage insulating plate 13 through insulating rings, and both of the tops of the sixth connection component 21 and the seventh connection component 22 protrude from the upper surface of the high-low voltage insulating plate. The eighth connection component 23 is a ring-shaped structure connected with a high-voltage end of a shielding branch low-voltage resistor 9, which is configured for parallel connection of at least two shielding branch low-voltage resistors 9. The shielding branch low-voltage resistors are arranged uniformly in a circular pattern. The ninth connection component 24 is a cylindrical structure with a cylinder disposed thereon, and the diameter of the cylinder is equal to the inner diameter of the ring-shaped cylinder at the bottom of the sixth connection component 21. The cylindrical structure of the eighth connection component 23 is connected with a high-voltage end of a measurement branch low-voltage resistor 8, which is configured for parallel connection of least two measurement branch low-voltage resistors 8. The measurement branch low-voltage resistors are arranged uniformly in a circular pattern. In the practical application, the measurement branch low-voltage resistor 8 and the shielding branch low-voltage resistor 9 may be customized first, and then the measurement branch low-voltage resistor 8 and the shielding branch low-voltage resistor 9 are fixed through the eighth connection component 23, the ninth connection component 24 and a low-voltage resistor plate 14. Then, the seventh connection component 22 and the eighth connection component 23 are connected through bolts, and the ring-shaped cylinder of the sixth connection component 21 and the cylinder on the ninth connection component 24 are engaged with each other.

In some embodiments, by disposing spring contact fingers 34 on the annular grooves of the hollow columns disposed at the top and bottom of the second flange of the high-voltage module at the tail end of the high-voltage arm, conductivity between the third connection component 18 and the seventh connection component 22 on the high-voltage arm may be achieved, thereby achieving the electrical connection between the shielding branch high-voltage resistor on the high-voltage arm and the shielding branch low-voltage resistor on the low-voltage module. By mounting the spring contact fingers 34 at the positions of the annular grooves of the fifth connection component 20 on the second flange 12 of the high-voltage module at the tail end of the high-voltage arm, conductivity between the second connection component 17 and the sixth connection component 21 on the high-voltage arm may be achieved, thereby achieving the electrical connection between the measurement branch high-voltage resistor on the high-voltage arm and the measurement branch low-voltage resistor on the low-voltage module.

In large-voltage dividers in existing technology, since there is no shielding resistive voltage divider, a sectioning method is adopted (that is, multiple high-voltage resistors are connected in series to measure the voltage). However, since the shielding resistive voltage divider in the embodiment is divided into the inner measurement branch resistors and the outer shielding branch resistors, the resistors cannot be directly connected. Otherwise, shielding effects of the shielding branch resistors cannot be achieved. To this end, the connection manner designed in the embodiment adopts a modular design. At the same physical height of the same high-voltage module, potentials of the inner resistors are isolated from the potentials of the outer resistors by insulation. The electrical connection between the inner measurement branch resistors connected in series and the electrical connection between the outer shielding branch resistors connected in series are achieved by the spring contact fingers 34, which not only achieves the measurement of high voltage levels but also reduces the stray capacitance of the measurement branch and the shielding branch, thereby improving the response characteristics of the measurement branch. The external charged body only affects the stray capacitance to ground of the shielding resistor, which improves the measurement stability and anti-interference ability of the measurement branch. The spring contact fingers 34 in the embodiment may be made of copper alloy with a silver plating on the outer layer.

Similarly, for the high-voltage module at the tail end of the high-voltage arm, the third connection component 18 at the tail end is isolated from the second connection component 17 and the fifth connection component 20 through insulating materials, the hollow column on the second flange 12 is isolated from the fifth connection component 20 through insulating materials, and the sixth connection component 21 and the seventh connection component 22 of the low-voltage module are isolated from each other through an insulating ring. Therefore, when the electrical connection between the measurement branch high-voltage resistors of the high-voltage modules and the measurement branch low-voltage resistors of the low-voltage module, and the electrical connection between the shielding branch high-voltage resistors of the high-voltage modules and the shielding branch low-voltage resistors of the low-voltage module are achieved, the electrical isolation between the measurement branch high-voltage resistors and the shielding branch high-voltage resistors in the high-voltage module and the electrical isolation between the measurement branch low-voltage resistors and the shielding branch low-voltage resistors in the low-voltage module are also achieved. In the embodiment, when the multiple high-voltage modules 3 are connected in series, the turn spacing of the measurement branch high-voltage resistor and the shielding branch high-voltage resistor in the high-voltage module changes according to the distance to the low-voltage module. The closer to the low-voltage module is, the larger the turn spacing is.

In the embodiment, the resistor adopts the double-wire parallel double-wire parallel winding to reduce the stray inductance. To improve the voltage measurement level, for the 2400kV shielding resistive voltage division apparatus in the embodiment, the resistance value of the measurement branch high-voltage resistor of each high-voltage module is not less than 15kΩ, the diameter of the resistance wire is not less than 0.2mm, and the number of turns is determined according to the withstand voltage of the resistance wire. The shielding branch high-voltage resistor = the measurement branch resistor × (the diameter of the shielding branch high-voltage resistor / the diameter of the measurement branch high-voltage resistor).

In addition, the diameters of the resistance wires of the measurement branch high-voltage resistor and the shielding branch high-voltage resistor in the high-voltage module may also be different. The measurement branch high-voltage resistor has a smaller diameter and uses the resistance wires with a smaller diameter, while the shielding branch high-voltage resistor uses the resistance wires with a larger diameter, which may the resistance value of the outer layer, thereby reducing the equivalent resistance value of the high-voltage arm and consequently reducing the time constant.

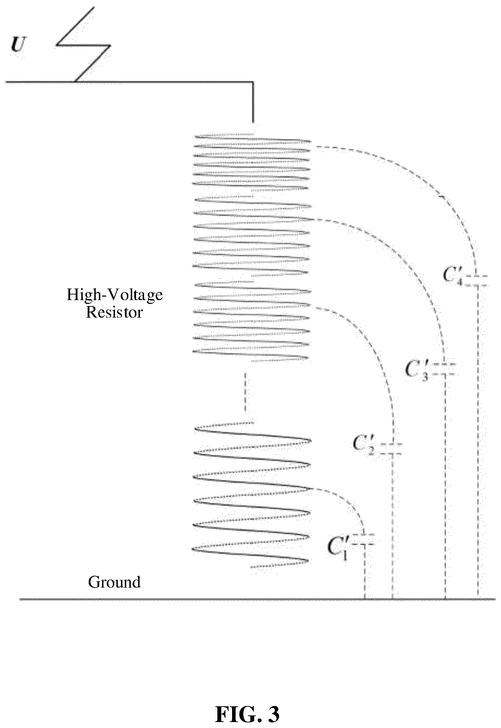

The stray capacitance to ground is the sum of the capacitance to ground of each turn of high-voltage winding. The stray capacitance cannot be directly calculated and may be equivalently estimated by finite element simulation software. However, the stray capacitance value may be approximately qualitatively determined by a formula for a parallel-plate capacitor ($C = \frac{\varepsilon S}{d}$, where S is the facing area and d is the distance). The larger the number of turns is, the greater the stray capacitance is. The longer the high-voltage arm is, the greater the stray capacitance is. The closer to ground is, the greater the equivalent capacitance is. Therefore, when the resistor of the high-voltage arm changes from high to low, the spacing between the resistance wires changes from dense to sparse, which may reduce the total value of the distribution capacitance to ground. FIG. 3 is a schematic diagram of distribution of the number of turns of a high-voltage resistor of a shielding resistive voltage divider provided by an embodiment of the present application. As shown in FIG. 3, for a high-voltage resistor obtained by connecting four high-voltage modules in series, the stray capacitance to ground from the head end to the tail end of the high-voltage arm is $C'_4$, $C'_3$, $C'_2$ and $C'_1$ respectively. The larger the number of turns of the resistor is, the greater the stray capacitance is; and the closer to ground is, the greater the equivalent capacitance is. Therefore, compared to the case where the number of turns of the resistor in each high-voltage module is the same, when the resistance values of the high-voltage modules decrease from the head end to the tail end of the high-voltage arm and the spacing between the resistance wires changes from dense to sparse, the value of the distribution capacitance to ground may be better reduced.

In some embodiments, a respective first grading ring 25 is disposed between the inner wall of the first insulating housing 7 and each end of the shielding branch high-voltage resistor 5.

A second grading ring 26 is disposed between any two adjacent high-voltage modules.

A third grading ring 27 is disposed at the top end of the first insulating housing of the high-voltage module at the head end of the high-voltage arm. The third grading ring is designed to be scalable, and the final height for disposing the third grading ring is determined according to a step wave response test result.

Referring to FIG. 1, the first grading ring is disposed within the first insulating housing, which is configured to make the electric field in the high-voltage module uniform. The second grading ring is disposed between the flanges of two adjacent high-voltage modules, which may be configured to make the external electric field uniform. The third grading ring is designed to be scalable, and the height for disposing the third grading ring may be adjusted to change the compensation effect of the stray capacitance of the grading ring.

In the embodiment, the shielding resistive voltage divider further includes a damping resistor 28 and a high-voltage guide rod 29.

The high-voltage guide rod 29 is disposed on the first flange 11 of the high-voltage module at the head end of the high-voltage arm. The damping resistor 28 is connected with the measurement branch high-voltage resistor 5 and the shielding branch high-voltage resistor 6 through a high-voltage lead wire 30 and the high-voltage guide rod 29 in sequence.

The specific resistance value of the damping resistor in the embodiment is determined by relative overshoot of the first oscillation in the step wave response waveform in the step wave response test. The withstand voltage of the resistance value is calculated according to the ratio of the damping resistor to the equivalent high-voltage resistor. If the voltage is high, a manner of a four-layer wire-wound resistor may be adopted to increase the number of turns and thermal capacity of the resistor. The high-voltage lead wire has a fixed length and width. In terms of the connection manner, a hollow column is disposed on the first flange of the high-voltage module at the head end of the high-voltage arm, and multiple annular grooves are formed along the circumference thereon. The diameter of the high-voltage guide rod 29 is slightly smaller than the diameter of the hollow column. By mounting two spring contact fingers 34 on the high-voltage guide rod 29, the spring contact fingers 34 are embedded in the two annular grooves of the first flange, thereby achieving the electrical connection between the high-voltage guide rod 29 and the first connection component 17 in the high-voltage module at the head end of the high-voltage arm.

In some embodiments, the low-voltage arm of the shielding resistive voltage divider further includes a first matching resistor 31 and a radio frequency cable socket 32 connected in parallel with the measurement branch low-voltage resistor.

Here, the radio frequency cable socket 32 is disposed on the lower flange 15 of the low-voltage module, and the radio frequency cable socket 32 is coaxial with the first matching resistor 31.

An end of the first matching resistor 31 is connected with the high-voltage end of the measurement branch low-voltage resistor 8, and the other end of the first matching resistor 31 is connected with the core wire of the cable installed in the radio frequency cable socket 32.

In the embodiment, the first matching resistor is employed to match the wave impedance of the cable, so as to reduce the waveform oscillation caused by reflection within the cable.

In some embodiments, the high-voltage module 3 and the low-voltage module 4 are internally air insulated.

In the embodiment, since the length of the high-voltage resistor of the shielding resistive voltage divider does not need to be compressed, air insulation may be adopted. Compared with the compressed resistive voltage divider, the outer diameter of the apparatus in the embodiment is significantly reduced, thereby reducing the size and weight of the shielding resistive voltage divider. Compared with the segmented resistive voltage divider, although the size is not significantly changed, the stray capacitance to ground of the measurement branch is reduced by disposing the shielding branch, thereby improving the high-frequency response characteristics of the voltage divider.

In some embodiments, a base 33 is disposed at the bottom of the lower flange 15 of the low-voltage module 4, and multiple wheels are installed on the base 33 to facilitate the movement of the shielding resistive voltage divider to the target working place.

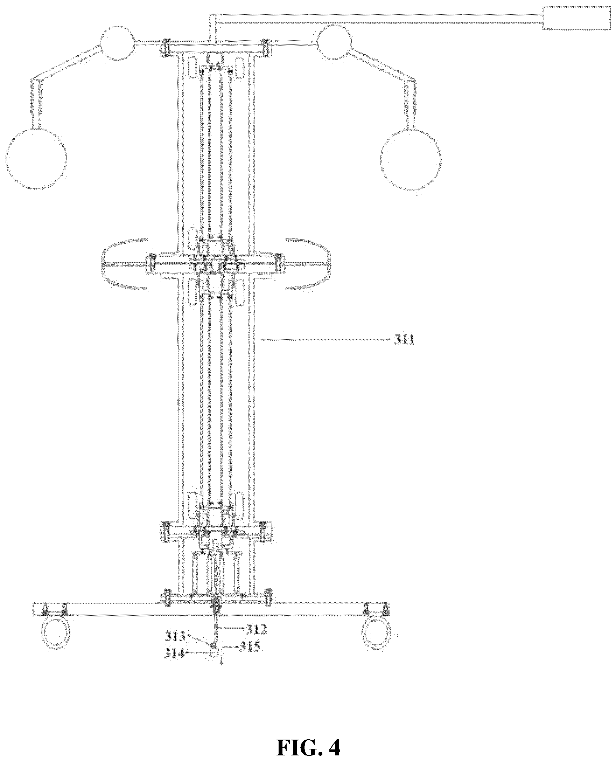

FIG. 4 is a schematic diagram of a structure of a shielding voltage division measurement apparatus provided by an embodiment of the present application. As shown in FIG. 4, the shielding voltage division measurement apparatus of the embodiment includes a shielding resistive voltage divider 311, a cable 312, a second matching resistor 313, a measurement instrument 314 and a shielding cabinet 315.

Here, the cable 312 is coaxially connected with a first matching resistor 31 of the shielding resistive voltage divider 311 and is connected in parallel with the second matching resistor 313. Here, the number of high-voltage modules to be installed in the shielding resistive voltage divider 311 is determined according to the voltage level to be measured.

The measurement instrument 314 is connected with the second matching resistor 313 and the cable 312, and is configured to measure a voltage. Here, the measurement instrument 314 and the second matching resistor 313 are sealed within the shielding cabinet 315.

In the embodiment, since the voltage level measurable by a single high-voltage module is 600kV and the voltage level to be measured is 1200kV, two high-voltage modules are connected in series to form the high-voltage arm. After connecting with the low-voltage arm, the formed shielding resistive voltage divider may meet the measurement requirements.

In the embodiment, on the basis of the first matching resistor of the shielding resistive voltage divider, a second matching resistor is connected in parallel at the tail end of the coaxial cable, which may further match the wave impedance of the cable and reduce the waveform oscillation caused by reflection within the cable.

In the embodiment, wires of the measurement instrument are wrapped with the coaxial cable and the measurement instrument is protected by the shielding cabinet, which may reduce the interference caused by external factors and improve the measurement accuracy.

Referring to FIG. 4, it can be known that in the embodiment, by coaxially disposing the shielding branch outside the measurement branch of the high-voltage module, the stray capacitance to ground of the measurement branch high-voltage resistor is greatly reduced, which is conducive to reducing the response time of the voltage division measurement apparatus. In addition, due to shunting of the shielding branch, the current in the measurement branch is reduced, which may reduce heat generation of the resistance wires and is conducive to improving the stability of the scaling factor.

In some embodiments, for the shielding resistive voltage division measurement apparatus of the present application, the actual voltage division ratio and measurement error in response to known impulse voltage waveforms may be determined through tests.

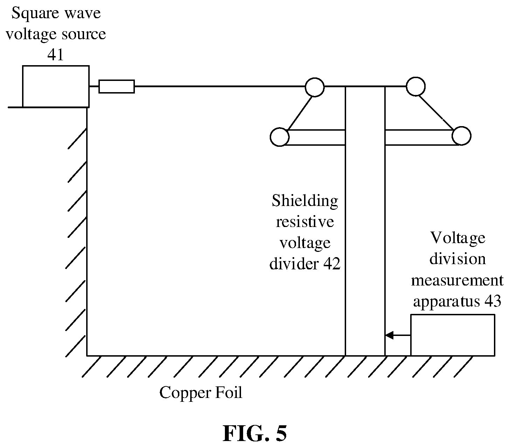

FIG. 5 is a schematic diagram of connection of a test circuit for measuring a voltage division ratio of a shielding resistive voltage division apparatus provided by an embodiment of the present application. As shown in FIG. 5, a square wave source 41 is connected with a head end of a shielding resistive voltage divider 42, and ground of the square wave source is connected with ground of a voltage division measurement apparatus 43 by a grounding copper foil. The method for determining the voltage division ratio by the voltage division measurement apparatus shown in FIG. 5 includes the following operations.

A characteristic time period for measuring a voltage division ratio of the shielding resistive voltage divider is determined according to a type of a known impulse voltage waveform.

An output voltage signal of the square wave source is measured multiple times within the characteristic time period based on an output voltage waveform of the square wave source. An output voltage average value $u1(t)$ of the output voltage waveform of the square wave source is calculated according to the measured output voltage signals.

Based on an output response signal generated by the shielding resistive voltage divider according to the waveform of the square wave source, the output response signal is measured and collected multiple times within the characteristic time period. A signal average value $u2(t)$ of the output response signal is calculated according to the output response signal, and a square wave response waveform of the shielding resistive voltage divider is determined according to the signal average value $u2(t)$.

An actual voltage division ratio of the shielding resistive voltage divider is calculated according to the output voltage average value $u1(t)$ and the signal average value $u2(t)$.

An output voltage waveform generated by the shielding resistive voltage divider in response to the known impulse voltage waveform is calculated according to the known impulse voltage waveform and the square wave response waveform.

Characteristic parameters of the known impulse voltage waveform and the output voltage waveform are calculated respectively, and a measurement error introduced by the shielding resistive voltage divider in response to the known impulse voltage waveform is calculated according to the characteristic parameters. Here, the characteristic parameters include a voltage peak UT, a wavefront time T1 and a half-peak time T2.

As is well known to those skilled in the art, as limited by the appended claims, embodiments other than those disclosed above fall equivalently within the scope of the present application.

Generally, all terms used in the claims are explained according to the ordinary meanings in the art, unless otherwise explicitly defined therein. All references to "a/the/said [apparatus, component, or the like]" are openly explained as at least one example of the apparatus, component, or the like, unless otherwise explicitly illustrated. The steps of any method disclosed herein need not be carried out in the disclosed exact order, unless explicitly illustrated otherwise.

It is to be understood by those skilled in the art that the embodiments of the present application may be provided as methods, systems, or computer program products. Therefore, the present application may be embodied in the form of an entirely hardware embodiment, an entirely software embodiment, or an embodiment combining software and hardware aspects. Furthermore, the present application may adopt the form of a computer program product implemented on one or more computer-usable storage media (including a disk memory, a CD-ROM, an optical memory, or the like, but not limited thereto) that contain computer-usable program codes therein.

The present application is described with reference to flowcharts and/or block diagrams according to methods, devices (systems), and computer program products of the embodiments of the present application. It is to be understood that each of the flows and/or blocks in the flowchart and/or block diagram, and a combination of flows and/or blocks in the flowchart and/or block diagram, may be implemented by computer program instructions. These computer program instructions may be provided to a processor of a general purpose computer, a special purpose computer, an embedded processor, or other programmable data processing devices to produce a machine, such that instructions executed by the processor of a computer or other programmable data processing devices produce an apparatus for implementing functions specified in one or more flows in the flowchart and/or one or more blocks in the block diagram.

These computer program instructions may also be stored in a computer-readable memory that may direct a computer or other programmable data processing devices to operate in a particular manner, such that instructions stored in the computer-readable memory produce a manufactured product including an instruction apparatus, and the instruction apparatus implements functions specified in one or more flows in the flowchart and/or one or more blocks in the block diagram.

These computer program instructions may also be loaded onto a computer or other programmable data processing devices, such that a series of operation steps are executed on the computer or other programmable devices to produce computer-implemented processing, and the instructions executed on the computer or other programmable devices provide steps for implementing functions specified in one or more flows in the flowchart and/or one or more blocks in the block diagram.

Finally, it is to be noted that the above embodiments are only used to illustrate the technical solutions of the present application, and not to limit the present application. Although the present application is illustrated in detail with reference to the above embodiments, those of ordinary skill in the art should understand that modifications or equivalent substitutions may still be made to the specific implementations of the present application, and any modifications or equivalent substitutions not departing from the spirit and scope of the present application shall be covered by the scope of protection of the claims of the present application.

**Claims**

1. A shielding resistive voltage divider, comprising a high-voltage arm and a low-voltage arm,

wherein the high-voltage arm comprises a plurality of high-voltage modules connected in series, and the low-voltage arm is a low-voltage module connected in series with a high-voltage module at a tail end of the high-voltage arm;
wherein for each high-voltage module of the plurality of high-voltage modules, the high-voltage module comprises a measurement branch high-voltage resistor and a shielding branch high-voltage resistor connected in parallel, and a first insulating housing, wherein the measurement branch high-voltage resistor and the shielding branch high-voltage resistor are coaxially disposed within the first insulating housing and are electrically isolated from each other, and the shielding branch high-voltage resistor is located outside the measurement branch high-voltage resistor;
the high-voltage module further comprises a first flange and a second flange;
the first flange is located at a top of the first insulating housing, and is configured to crimp the measurement branch high-voltage resistor and the shielding branch high-voltage resistor from the top; a hollow column is disposed at a bottom of the first flange, and a plurality of annular grooves are formed on an inner peripheral wall of the hollow column along an axial direction; and
the second flange is located at a bottom of the first insulating housing, and is configured to achieve connection between adjacent high-voltage modules and connection between the high-voltage module at the tail end of the high-voltage arm and the low-voltage module; wherein in a high-voltage module that is not at the tail end of the high-voltage arm, a hollow column is disposed at a top of the second flange, and a plurality of annular grooves are formed on an inner peripheral wall of the hollow column along an axial direction; and in the high-voltage module at the tail end of the high-voltage arm, a respective hollow column is disposed on each of the top and a bottom of the second flange, and a plurality of annular grooves are formed on an inner peripheral wall of each hollow column along an axial direction;
wherein the low-voltage module comprises a measurement branch low-voltage resistor and a shielding branch low-voltage resistor connected in parallel, and a second insulating housing, wherein the measurement branch low-voltage resistor and the shielding branch low-voltage resistor are coaxially disposed within the second insulating housing, a high-voltage end of the measurement branch low-voltage resistor and a high-voltage end of the shielding branch low-voltage resistor are electrically isolated from each other, and the shielding branch low-voltage resistor is located outside the measurement branch low-voltage resistor;
the low-voltage module further comprises a high-low voltage insulating plate, a low-voltage resistor base plate and a lower flange, wherein the low-voltage resistor base plate is configured to fix low-voltage ends of the measurement branch low-voltage resistor and the shielding branch low-voltage resistor, the high-low voltage insulating plate is crimped to a top of the second insulating housing, the lower flange is crimped to the low-voltage resistor base plate and a bottom of the second insulating housing, and is configured to fix the measurement branch low-voltage resistor and the shielding branch low-voltage resistor; and
measurement branch high-voltage resistors in the plurality of high-voltage modules are electrically connected through at least one connection metal component, shielding branch high-voltage resistors in the plurality of high-voltage modules are electrically connected through at least one connection metal component, a measurement branch high-voltage resistor in the high-voltage module at the tail end of the high-voltage arm and the measurement branch low-voltage resistor in the low-voltage module are electrically connected through at least one connection metal component, and a shielding branch high-voltage resistor in the high-voltage module at the tail end of the high-voltage arm and the shielding branch low-voltage resistor in the low-voltage module are electrically connected through at least one connection metal component.

2. The shielding resistive voltage divider of claim 1, wherein the measurement branch high-voltage resistors in the plurality of high-voltage modules are electrically connected through the at least one connection metal component, the shielding branch high-voltage resistors in the plurality of high-voltage modules are electrically connected through the at least one connection metal component, the measurement branch high-voltage resistor in the high-voltage module at the tail end of the high-voltage arm and the measurement branch low-voltage resistor in the low-voltage module are electrically connected through the at least one connection metal component, and the shielding branch high-voltage resistor in the high-voltage module at the tail end of the high-voltage arm and the shielding branch low-voltage resistor in the low-voltage module are electrically connected through the at least one connection metal component, comprises:

in a high-voltage module at a head end of the high-voltage arm, a first connection component is disposed at head ends of the measurement branch high-voltage resistor and the shielding branch high-voltage resistor, a second connection component is disposed at an tail end of the measurement branch high-voltage resistor, and a third connection component is disposed at an tail end of the shielding branch high-voltage resistor;

in a high-voltage module that is not at the head end of the high-voltage arm, the second connection component is disposed at the head end and the tail end of the measurement branch high-voltage resistor, and the third connection component is disposed at the head end and the tail end of the shielding branch high-voltage resistor;

in the high-voltage module that is not at the tail end of the high-voltage arm, a fourth connection component is disposed on the second flange, wherein the fourth connection component is coaxially disposed with the second connection component;

in the high-voltage module at the tail end of the high-voltage arm, a fifth connection component is disposed on the second flange, and in the high-voltage module that is not at the head end of the high-voltage arm, the fifth connection component is disposed on the first flange, wherein the fifth connection component is coaxially disposed with the second connection component;

a sixth connection component and a seventh connection component are fixed on the high-low voltage insulating plate of the low-voltage module, wherein the sixth connection component and the seventh connection component are coaxially disposed with the fifth connection component; and

in the low-voltage module, an eighth connection component is disposed at the high-voltage end of the measurement branch low-voltage resistor, and a ninth connection component is disposed at the high-voltage end of the shielding branch low-voltage resistor.

3. The shielding resistive voltage divider of claim 1, wherein in each high-voltage module of the plurality of high-voltage modules, the measurement branch high-voltage resistor and the shielding branch high-voltage resistor are double-wire parallel wound around an insulating support rod, the measurement branch high-voltage resistor and the shielding branch high-voltage resistor have a consistent potential at a same physical height, a same number of turns, and an equal turn spacing; wherein when the measurement branch high-voltage resistor and the shielding branch high-voltage resistor are wound with resistance wires of a same diameter, a ratio of resistance values is equal to a ratio of resistor diameters, and when the measurement branch high-voltage resistor and the shielding branch high-voltage resistor are wound with resistance wires of different diameters, a diameter of a resistance wire of the measurement branch high-voltage resistor is smaller than a diameter of a resistance wire of the shielding branch high-voltage resistor.

4. The shielding resistive voltage divider of claim 3, wherein when the plurality of high-voltage modules are connected in series, a turn spacing of the measurement branch high-voltage resistor and the shielding branch high-voltage resistor in the high-voltage module changes according to a distance to the low-voltage module, and the closer to the low-voltage module is, the larger the turn spacing is.

5. The shielding resistive voltage divider of claim 1, wherein a respective first grading ring is disposed between each end of the shielding branch high-voltage resistor and an inner wall of the first insulating housing;

a second grading ring is disposed between any two adjacent high-voltage modules; and a third grading ring is disposed at a top end of a first insulating housing of a high-voltage module at a head end of the high-voltage arm, wherein the third grading ring is designed to be scalable, and a final height for disposing the third grading ring is determined according to a step wave response test result.

6. The shielding resistive voltage divider of claim 1, further comprising a damping resistor and a high-voltage guide rod,
wherein the high-voltage guide rod is disposed on a first flange of a high-voltage module at a head end of the high-voltage arm, and the damping resistor is connected with the measurement branch high-voltage resistor and the shielding branch high-voltage resistor through a high-voltage lead wire and the high-voltage guide rod in sequence.

7. The shielding resistive voltage divider of claim 1, wherein the low-voltage arm further comprises a first matching resistor and a radio frequency cable socket connected in parallel with the measurement branch low-voltage resistor,

wherein the radio frequency cable socket is disposed on the lower flange of the low-voltage module, and the radio frequency cable socket is coaxial with the first matching resistor; and an end of the first matching resistor is connected with the high-voltage end of the measurement branch low-voltage resistor, and another end of the first matching resistor is connected with a core wire of a cable installed in the radio frequency cable socket.

8. The shielding resistive voltage divider of claim 1, wherein the high-voltage module and the low-voltage module are internally air insulated.

9. A shielding resistive voltage division measurement apparatus, comprising a shielding resistive voltage divider, a cable, a second matching resistor, a measurement instrument and a shielding cabinet,

wherein the cable is coaxially connected with a first matching resistor of the shielding resistive voltage divider and is connected in parallel with the second matching resistor, wherein a number of high-voltage modules to be installed in the shielding resistive voltage divider is determined according to a voltage level to be measured; and the measurement instrument is connected with the second matching resistor and the cable, and is configured to measure a voltage, wherein the measurement instrument and the second matching resistor are sealed within the shielding cabinet.

**FIG. 1**

**FIG. 2**

$U$

High-Voltage
Resistor

$C'_4$

$C'_3$

$C'_2$

$C'_1$

Ground

**FIG. 3**

FIG. 4

Square wave
voltage source
41

Shielding
resistive
voltage
divider 42

Voltage
division
measurement
apparatus 43

Copper Foil

**FIG. 5**

## INTERNATIONAL SEARCH REPORT

| International application No. |
|---|
| **PCT/CN2023/121097** |

**A. CLASSIFICATION OF SUBJECT MATTER**

G01R15/04(2006.01)i

According to International Patent Classification (IPC) or to both national classification and IPC

**B. FIELDS SEARCHED**

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

CJFD, ENTXTC, CNTXT: 屏蔽, 低压, 电阻分压器, 高压, shielding, resistance voltage divider, high-voltage, low-voltage

**C. DOCUMENTS CONSIDERED TO BE RELEVANT**

| Category* | Citation of document, with indication, where appropriate, of the relevant passages | Relevant to claim No. |
|---|---|---|
| PX | CN 115629229 A (CHINA ELECTRIC POWER RESEARCH INSTITUTE et al.) 20 January 2023 (2023-01-20) <br> claims 1-10 | 1-9 |
| Y | CN 113721060 A (CHINA ELECTRIC POWER RESEARCH INSTITUTE CO., LTD.) 30 November 2021 (2021-11-30) <br> description, paragraphs 43-72, and figures 1-5 | 1-9 |
| Y | CN 102565487 A (ZHUAHAI WEIHAN TECHNOLOGY DEVELOPMENT CO., LTD.) 11 July 2012 (2012-07-11) <br> description, paragraphs 15-21, and figures 1-5 | 1-9 |
| A | CN 217035376 U (XI'AN XD HIGH VOLTAGE APPARATUS CO., LTD. et al.) 22 July 2022 (2022-07-22) <br> entire document | 1-9 |
| A | JP H06242148 A (NIPPON KOGYO UNIVERSITY) 02 September 1994 (1994-09-02) <br> entire document | 1-9 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **11 January 2024** | **12 January 2024** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
|---|
| **PCT/CN2023/121097** |

### C. DOCUMENTS CONSIDERED TO BE RELEVANT

| Category* | Citation of document, with indication, where appropriate, of the relevant passages | Relevant to claim No. |
|---|---|---|
| A | RU 166007 U1 (IVANOVO STATE POWER ENGINEERING UNIVERSITY) 10 November 2016 (2016-11-10)<br>entire document | 1-9 |
| A | US 5122730 A (UNITED STATES AIR FORCE) 16 June 1992 (1992-06-16)<br>entire document | 1-9 |
| A | WO 2019227826 A1 (GLOBAL ENERGY INTERCONNECTION RESEARCH INSTITUTE CO., LTD. et al.) 05 December 2019 (2019-12-05)<br>entire document | 1-9 |

Form PCT/ISA/210 (second sheet) (July 2022)

## INTERNATIONAL SEARCH REPORT
### Information on patent family members

International application No.

**PCT/CN2023/121097**

| Patent document cited in search report | | | Publication date (day/month/year) | Patent family member(s) | | | Publication date (day/month/year) |
|---|---|---|---|---|---|---|---|
| CN | 115629229 | A | 20 January 2023 | None | | | |
| CN | 113721060 | A | 30 November 2021 | None | | | |
| CN | 102565487 | A | 11 July 2012 | None | | | |
| CN | 217035376 | U | 22 July 2022 | None | | | |
| JP | H06242148 | A | 02 September 1994 | None | | | |
| RU | 166007 | U1 | 10 November 2016 | None | | | |
| US | 5122730 | A | 16 June 1992 | None | | | |
| WO | 2019227826 | A1 | 05 December 2019 | EP | 3780040 | A1 | 17 February 2021 |
| | | | | EP | 3780040 | B1 | 19 October 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211616418